# EUROPEAN PATENT SPECIFICATION

(11) **EP 2 751 534 B1**
(45) Date of publication and mention of the grant of the patent: **06.03.2019**
(21) Application number: 12784068.4
(22) Date of filing: 31.08.2012
(51) Int. Cl.: G01K 1/14, G01K 1/02

(54) **SYSTEM FOR MONITORING ELECTRIC SUPPLY LINES**
SYSTEM ZUR ÜBERWACHUNG VON STROMVERSORGUNGSLEITUNGEN
SYSTÈME DE SURVEILLANCE DE LIGNES D'ALIMENTATION ÉLECTRIQUE

(30) Priority: 31.08.2011 NO 20111180
(43) Date of publication of application: 09.07.2014
(73) Proprietor: Heimdall Power AS, 5042 Bergen (NO)
(72) Inventor: KNOOP, Kjell, B-4800 Verviers (BE)
(74) Representative: Onsagers AS
(86) International application number: PCT/IB2012/054492
(87) International publication number: WO 2013/030796

(56) References cited:
- US-A- 4 777 381
- US-A- 5 140 257
- US-A1- 2007 041 333
- US-A1- 2009 240 449

## Description

The invention relates to a system and method for monitoring wind loads, temperatures, tension and /or height in electrical supply installations using RFID technology. Regulations relating to electrical supply installations were established by the Norwegian
Directorate for Civil Protection and Emergency Planning (DSB) on 20 December 2005 and came into force on 1 January 2006 under the authority of Act No. 4 of 24 May 1929 relating to the supervision of electrical installations and electrical equipment. These Regulations replace the Regulations of 18 August 1994 relating to electrical installations and supply installations.

The object of the Regulations is that electrical supply installations should be projected, constructed, operated and maintained in such a way that they do not pose a hazard to life, health and material assets, and at the same time perform the function for which they are intended. These guidelines are aimed at owners and operators of electrical supply installations. Those responsible for the projection, construction, alteration, operation or maintenance of installations are responsible for ensuring that installations included in their activities are in compliance with the requirements laid down in the Regulations. Everyone responsible for projection, construction or alteration of installations must issue a declaration stating that the installation has been constructed in accordance with the requirements set forth in the Regulations.

For high-voltage overhead power lines, the following applies in particular:
Overhead power lines should be inspected to the extent necessary in order to check that they are in the required condition.

### Conducting line inspection:

Line inspection must be carried out when lines have been subjected to abnormal impacts and at least once a year. Line inspection should be documented by line inspection reports.

A line inspection includes checking both mechanical components (foundation, post) and the actual electric installation (insulators, lines and switches etc.). A line inspection of the electrical installation is often performed today with the aid of thermal photography from a helicopter and manual inspection on the ground. An IR camera detects abnormal heat generation, as a result of, inter alia, loose connections and defective/worn components. Such abnormal heat generation indicates a fault, and the fault can be remedied before the heat generation results in a breakdown or failure of the electrical supply installation.

It is normal for the lines to sway in the wind, but it is desirable to limit the movements such that the mechanical forces taken up at the support points are not too great. There are several ways of restricting the movements, e.g., by hanging weights on the line.

Breaks in power cables can have major consequences and cause many people to be without power, and in connection with serious incidents the compensation payments may be large.

All power network companies bear an economic responsibility in the event of long breaks in the power supply.

If damage happens to cables/lines for the highest voltages, which also are those that transfer most energy, the compensation payments may be extremely high. By way of illustration: If Drammen is blacked out for one hour, this corresponds to power cut costs of about NOK 5 million.

Reference is made here to the Norwegian Electrical Supervision Act, but other countries have similar legislation. Examples of prior art technology can be found in US 5 140 257 A, US 4 777 381 A, US 2007/041333 A1 and US 2009/240449 A1.

In view of, inter alia, the above, it is desirable to have more improvements. By means of the invention according to the patent claims, a number of advantages are obtained:
- Almost continuous monitoring of the electrical supply installation makes it possible to warn of increased temperature in the installation at an early stage so that the fault can be repaired in time.
- The wind load can be measured accurately and indicate to the owner/user of the installation whether there is a need to implement measures to limit the physical movements of the line.
- The costs will over time be lower than for the use of a helicopter and manual line inspection.

These improvements will result in:
- Increased safety for the users.
- Increased supply reliability.
- Lower operating costs.

The object of the invention is to provide a system and method for measuring wind loads, hindering overheating and preventing fire in electrical supply installations. This is achieved by means of a system for measuring wind strengths and fire prevention in electrical supply installations as in the patent claims.

In an embodiment, a sensor system for monitoring temperature loads, wind strength, tension and / or height in electrical supply installations comprises:
- at least two sensor devices arrangeable in series at positions in the electrical supply installation to be monitored; where each sensor device comprises a RFID signal transmitter capable of receiving and responding to radio frequency signals, and a signal receiver, where the sensor devices are adapted to communicate with and receive signals from the RFID signal transmitters of another sensor device and relaying them; and
- a reading unit connected to at least one of the signal receivers to process the signals and provide an indication signal, where the reading unit is in communication with an alarm centre, mobile phone or computer. Positions in the electrical supply installation may, for example, be one or more points along/by power lines, bus bars, circuit breakers (contacts/SF6/oil), GIS (contacts/SF6/bus bars/outlets), isolating blades (contacts), current transformers, voltage transformers, power transformers (windings) etc.

In an aspect of the invention, the sensor devices comprise wind strength sensor, temperature sensor, tension sensor, height sensor or a combination thereof. The sensor devices, in one embodiment, have physical contact with the electrical supply installation that is to be monitored. In an embodiment, corona discharges can also be detected by the system.

In an aspect of the invention, the signal transmitters and signal receivers are electromagnetic signal transmitters and readers.

One or more of the sensor devices may be connected to a signal receiver such that they comprise both signal transmitter and receiver. In these cases, the sensor devices may be capable of receiving signals from another sensor device, for example, a neighbouring sensor device, and relaying them.

In an embodiment, the sensor devices are electrically connected to the electrical supply installation and the electrical supply installation is energy source for the sensor devices. The sensor device may also comprise a transformer for transforming voltage from high voltage to distribution voltage. The system may also comprise means for measuring the electrical load on the sensor device(s).

In an aspect of the invention, the processing unit is connected to means for communicating wirelessly with an external unit for transmitting the indication signal or other information related to the indication signal. The external unit may, for example, be an alarm centre, mobile phone, computer etc.

The object of the invention is achieved also by means of a method for monitoring loads, wind strength, tension and/or height in electrical supply installations which comprises:
- placing at least two sensor devices at positions in the electrical supply installation to be monitored, where each sensor device comprises a RFID signal transmitter capable of receiving and responding to radio frequency signals;
- transmitting a sensor signal from one of the sensor devices by means of its RFID signal transmitter;
- receiving a signal from the RFID signal transmitter by means of the one or more signal receivers and relaying the received signals; and
- processing the signals and providing an indication signal which is communicated to an alarm centre, mobile phone or computer.

The invention will now be described in more detail and with reference to the attached figures.
Figure 1 illustrates the principles of the system according to the invention.
Figure 2 shows the mounting of an embodiment of a sensor device according to the invention.
Figure 3 shows an embodiment of a sensor device according to the invention prior to mounting.
Figure 4 shows an embodiment of a sensor device according to the invention after mounting.
Figure 5 shows a section through a sensor device as shown in Figures 3 and 4.

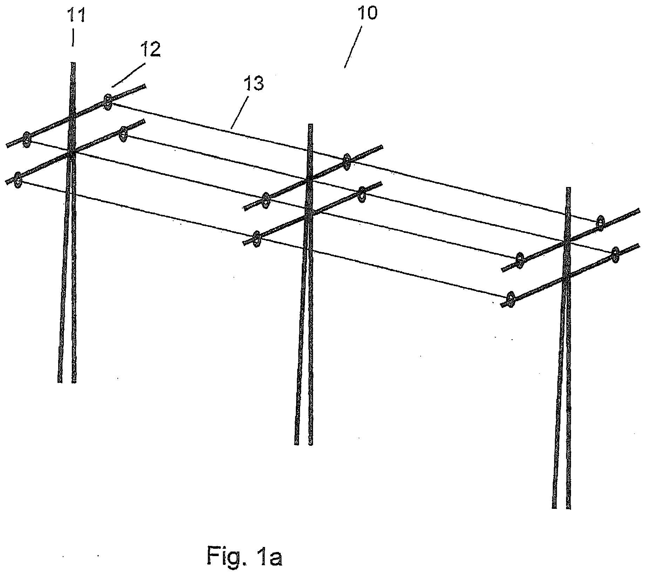

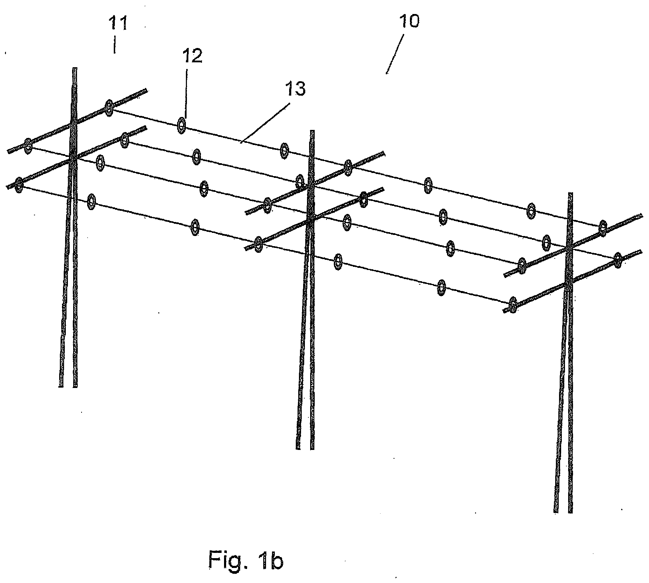

Figures 1a and 1b illustrate two embodiments of a sensor system for monitoring an electrical supply installation 10 comprising a plurality of high-voltage poles or pylons 11 on which high-voltage lines 13 are strung. Sensor devices 12 are arranged at a number of positions in the electrical supply installation, in this case along the high-voltage lines 13. The sensor devices 12 comprise one or more sensors for measuring properties that it is wished to have monitored by the system. For example, the sensors may be temperature sensors, wind strength sensors, tension sensors, height sensors, electrical field sensors etc. Connected to the sensor devices is a signal transmitter that is capable of transmitting measured data from the sensors. One such transmitter is an RFID chip (radio frequency identification chip). An RFID chip contains antennas that render it capable of receiving and responding to radio frequency signals from an RFID transceiver. The chip responds at least with its unique identifier, an ID number. There are several types of RFID chips. Passive chips respond with a weak radio signal and need no power source, whilst active chips transmit a more powerful response signal over a slightly greater distance and requires a power source. A third alternative is semi-passive chips which must have an external source to initiate transmission/response, but which have higher transmission strength and thus a greater range.

Examples of alternative signal transmitters are optical transmitters and SAW-based transmitters, for example, SAW-based RFID chips.

The system also comprises one or more signal receivers for communicating with and receiving signals from the signal transmitters. The signal receivers are arranged in all of the sensor devices 12, on one or more of the high-voltage poles 11 or other suitable point. In Figure 1a the sensor devices 12 are arranged on the high-voltage lines 13 at each of the high-voltage poles 11, whilst in Figure 1b sensor devices 12 are arranged at several positions along the high-voltage lines. In these cases, the sensor devices may have the capability of receiving signals from another sensor device, for example, a neighbouring sensor device, and relaying them. The sensor devices with signal transmitters and signal receivers constitute in this case a node in a sensor network.

The system provides the possibility of continuous monitoring and alerting of, for example, temperature changes and measuring wind gusts in the electrical supply installation. The system may have a transponder that communicates wirelessly with RFID chips. In addition, the RFID chips can communicate wirelessly with each other. The transponder relays the information to a reading unit. The reading unit communicates with a monitoring and alarm centre, mobile phone or the like. This makes it possible for the operator to intervene before the temperature in the electrical supply installation reaches a harmful level. It is also possible to detect how much a line is swaying in the wind by means of the aforementioned sensors. The data retrieved from the RFID system provides the operator with the necessary information to assess whether there are grounds for carrying out a closer inspection of the electrical supply installation. In short, the system will make it possible to leave parts of the line inspection to the electronic system.

In an embodiment, corona discharges can also be detected by the system. Corona discharges are partial discharges around conductors due to a high electrical field. Free electrons in the air around the conductor at field strengths of more than 30kW/cm have enough energy to ionise the oxygen molecules. The ions bombard the insulating material and can form conductive channels through the insulation, which in turn may lead to breakdown and arcing between conductors or between conductors and earth. Air gaps, open bars and sharp edges are common causes of corona discharges.

The discharges around high-voltage lines destroy the insulation and create radio noise. This is due to the fact that the oxygen molecules are ionised and form ozone, which breaks down the insulating material. Positive and negative ions produce red-green light and radio waves that disturb radio signals.

In a sensor network/system as described above based on RFID technology, electronic information is transmitted and received in the radio frequency range. The radio part of the nodes will be able to detect corona (disturbances in the radio wave range), and relay this in the network. By comparing the node's unique ID and the intensity of the radio noise, the receiver will be able to identify the location of the corona discharge.

An electrical supply installation may be many miles long. The distance between two poles may be several hundred metres. In order to obtain a satisfactory range in these cases, the RFID chip must therefore be active - that is to say, have its own power supply. At the same time, the power supply should not be based on battery operation that typically must be replaced each year.

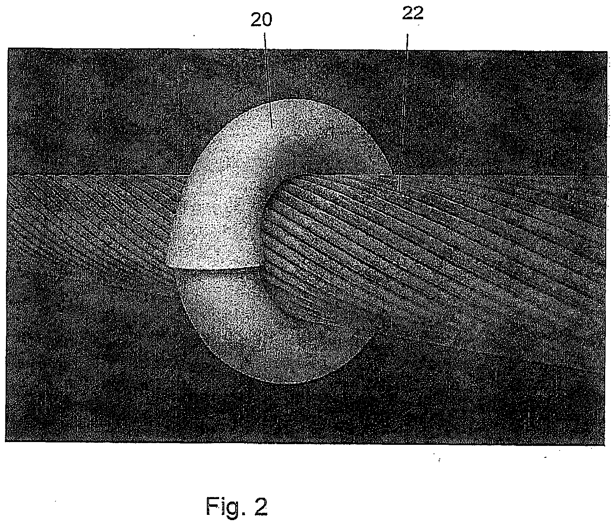

Figure 2 shows an example of how a sensor device 20 according to the invention can be mounted on a high-voltage line 22.

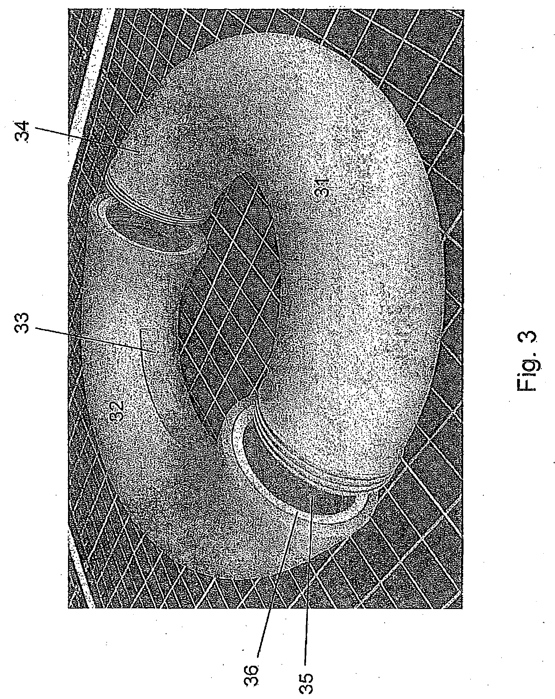

Figure 3 shows an embodiment of a sensor device 20 according to the invention prior to mounting. The sensor device 20 has the shape of a doughnut and comprises two parts 31 and 32 which, when mounted, are clamped together over the cable which constitutes a high-voltage line. The two parts of the sensor device have an outer housing 34 and an inner core 35. The outer housing 34 is made of an insulating and waterproof material. The inner core 35 is, for example, an iron core or a core of another electrically conductive material. A gasket 36 is disposed between the two parts 31 and 32 to provide a watertight joining thereof. Integral in the sensor device is a sensor 33 that is arranged along the inner ring of the doughnut such that it will come into contact with the cable when the sensor device has been mounted. The sensor device 20 also comprises a signal transmitter connected to the sensor device, for example, in the form of an RFID chip. The sensor device 20 also comprises a transformer that receives current from the high-voltage line and transforms it to the desired voltage level for the signal transmitter/RFID chip. The transformer may also measure the load on the line, i.e., the electrical energy. This information is useful for network owners (owner/user of the supply installation), because he can monitor and make use of the built-in safety margins in the line network.

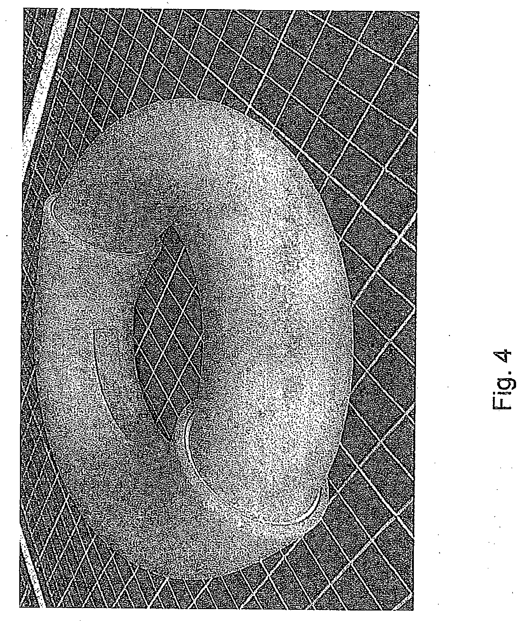

Figure 4 shows an embodiment of a sensor device according to the invention after mounting, where the two parts are clamped together so that the sensor device forms a closed, waterproof unit.

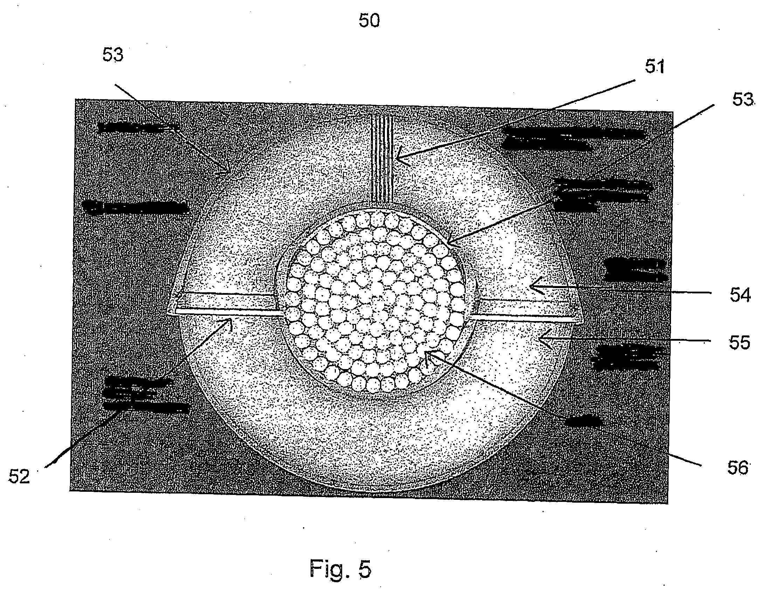

In Figure 5, the sensor device of Figures 3 and 4 is seen in section. The sensor device 50 here is arranged on a cable 56 and consists of two parts that are clamped together. The sensor device is doughnut-shaped and has an outside surface 53 of insulating plastic material and an inner iron core 54, 55. A sensor 53 is arranged on the side of the sensor device that is in contact with the cable 56. The sensor 53 and signal transmitter and optionally a signal reader connected to the sensor utilise the current in the cable as energy source via a coil 51 wound around the iron core and connected to an electronic circuit which transforms the voltage in the cable to the right voltage level.

The RFID chip is connected to the secondary side of the transformer. The illustrated solution allows the sensor device to be mounted on the line without the line being disconnected from the insulator.

## Claims

1. A sensor system for monitoring temperature loads, wind strength, tension and /or height on electrical supply installations comprising
- at least two sensor devices arrangeable in series in the electrical supply installation to be monitored; where each sensor device comprises a RFID signal transmitter capable of receiving and responding to radio frequency signals, and further comprises a signal receiver where the sensor devices are adapted to communicate with and receive signals from the RFID signal transmitters of another sensor device and relaying them; and
- a reading unit connected to at least one of the signal receivers to process the signals and provide an indication signal, where the reading unit is in communication with an alarm center, mobile phone or computer.

2. A system according to claim 1, wherein the sensor devices comprise temperature sensor, wind strength sensor, tension sensor and/or height sensor.

3. A system according to claim 1, comprising means for measuring the electrical load at the sensor device(s).

4. A system according to claim 1, wherein the signal transmitters and signal receivers are electromagnetic signal transmitters and readers.

5. A system according to claim 1, wherein the sensor devices are electrically connected to the electrical supply installation, the electrical supply installation serving as energy source for the sensor devices.

6. A system according to claim 1, wherein the sensor device has physical contact with the electrical supply installation that is to be monitored.

7. A system according to claim 1, wherein the processing unit is connected to the means for communicating wirelessly with an external unit for transmission of the indication signal or other information related to the indication signal.

8. A system according to claim 7, wherein the external unit is an alarm centre, mobile telephone, computer or the like.

9. A system according to claim 6, wherein the sensor device comprises a transformer for transforming voltage from high voltage to distribution voltage.

10. A method for monitoring temperature loads, wind strength, tension and/or height in electrical supply installations comprising:
- placing at least two sensor devices as in anyone of claims 1 to 9 in the electrical supply installation to be monitored, where each sensor device comprises a RFID signal transmitter capable of receiving and responding to radio frequency signals,
- transmitting sensor signals from one of the sensor devices by means of its RFID signal transmitter;
- receiving signals from the RFID signal transmitter by means of the one or more signal receivers and relaying the received signals; and
- processing the signals and providing an indication signal which is communicated to an alarm center, mobile phone or computer.

11. A method according to claim 10, wherein the sensor devices measure wind strength, tension and/or height above the ground.

12. A method according to claim 10, wherein the signal transmitters and signal receivers are electromagnetic signal transmitters and readers.

13. A method according to claim 10, wherein the signal received from another sensor device is relayed by means of the signal transmitter.

## Patentansprüche

1. Sensorsystem zum Überwachen von Temperaturlasten, Windstärke, Spannung und/oder Höhe an Stromversorgungsanlagen, umfassend
- mindestens zwei Sensorvorrichtungen, die in Reihe in der Stromversorgungsanlage, die zu überwachen ist, anordenbar sind; wobei jede Sensorvorrichtung einen RFID-Signalsender umfasst, der in der Lage ist, Hochfrequenzsignale zu empfangen und auf diese zu antworten,
und ferner einen Signalempfänger umfasst, wobei die Sensorvorrichtungen geeignet sind, mit den RFID-Signalsendern einer anderen Sensorvorrichtung zu kommunizieren und Signale von diesen zu empfangen und diese weiterzuleiten; und
- eine Leseeinheit, die mit mindestens einem der Signalempfänger verbunden ist, um die Signale zu verarbeiten und ein Anzeigesignal bereitzustellen, wobei die Leseeinheit in Kommunikation mit einer Alarmzentrale, einem Mobiltelefon oder einem Computer steht.

2. System nach Anspruch 1, wobei die Sensorvorrichtungen einen Temperatursensor, Windstärkensensor, Spannungssensor und/oder Höhensensor umfassen.

3. System nach Anspruch 1, umfassend Mittel zum Messen der elektrischen Last an der/den Sensorvorrichtung(en).

4. System nach Anspruch 1, wobei die Signalsender und die Signalempfänger elektromagnetische Signalsender und -leser sind.

5. System nach Anspruch 1, wobei die Sensorvorrichtungen elektrisch mit der Stromversorgungsanlage verbunden sind, wobei die Stromversorgungsanlage als Energiequelle für die Sensorvorrichtungen dient.

6. System nach Anspruch 1, wobei die Sensorvorrichtung einen physischen Kontakt mit der Stromversorgungsanlage, die zu überwachen ist, hat.

7. System nach Anspruch 1, wobei die Verarbeitungseinheit mit dem Mittel zur drahtlosen Kommunikation mit einer externen Einheit zur Übertragung des Anzeigesignals oder anderer Informationen, die sich auf das Anzeigesignal beziehen, verbunden ist.

8. System nach Anspruch 7, wobei die externe Einheit eine Alarmzentrale, ein Mobiltelefon, ein Computer oder Ähnliches ist.

9. System nach Anspruch 6, wobei die Sensorvorrichtung einen Transformator umfasst, um die Spannung von Hochspannung in Versorgungsspannung umzuwandeln.

10. Verfahren zum Überwachen von Temperaturlasten, Windstärke, Spannung und/oder Höhe an Stromversorgungsanlagen, umfassend
- Anordnen von mindestens zwei Sensorvorrichtungen nach einem der Ansprüche 1 bis 9 in der Stromversorgungsanlage, die zu überwachen ist, wobei jede Sensorvorrichtung einen RFID-Signalsender umfasst, der in der Lage ist, Hochfrequenzsignale zu empfangen und auf diese zu antworten,
- Übertragen von Sensorsignalen von einer der Sensorvorrichtungen mittels ihres RFID-Signalsenders;
- Empfangen von Signalen vom RFID-Signalsender mittels des einen oder der mehreren Signalempfänger(s) und Weiterleiten der empfangenen Signale; und
- Verarbeiten der Signale und Bereitstellen eines Anzeigesignals, das an eine Alarmzentrale, ein Mobiltelefon oder einen Computer kommuniziert wird.

11. Verfahren nach Anspruch 10, wobei die Sensorvorrichtungen die Windstärke, Spannung und/oder Höhe über dem Boden messen.

12. Verfahren nach Anspruch 10, wobei die Signalsender und die Signalempfänger elektromagnetische Signalsender und -leser sind.

13. Verfahren nach Anspruch 10, wobei das Signal, das von einer anderen Sensorvorrichtung empfangen wird, mittels des Signalsenders weitergeleitet wird.

## Revendications

1. Système de capteurs pour surveiller des charges de température, une force du vent, une tension et/ou une hauteur sur des installations d'alimentation électrique comprenant
- au moins deux dispositifs de capteur susceptibles d'être agencés en série dans l'installation d'alimentation électrique à surveiller; où chaque dispositif de capteur comprend un émetteur de signaux RFID propre à recevoir et à répondre à des signaux radiofréquence, et comprend en outre un récepteur de signal, où les dispositifs de capteur sont adaptés pour communiquer avec et recevoir des signaux en provenance des émetteurs de signaux RFID d'un autre dispositif de capteur et de les relayer ; et
- une unité de lecture connectée à au moins l'un des récepteurs de signaux pour traiter les signaux et fournir un signal d'indication, où l'unité de lecture est en communication avec un centre de surveillance, un téléphone mobile ou un ordinateur.

2. Système selon la revendication 1, dans lequel les dispositifs de capteur comprennent un capteur de température, un capteur de force du vent, un capteur de tension et/ou un capteur de hauteur.

3. Système selon la revendication 1, comprenant des moyens de mesure de la charge électrique au niveau du ou des dispositif(s) de capteur.

4. Système selon la revendication 1, dans lequel les émetteurs de signaux et les récepteurs de signaux sont des émetteurs et des lecteurs de signaux électromagnétiques.

5. Système selon la revendication 1, dans lequel les dispositifs de capteur sont connectés électriquement à l'installation d'alimentation électrique, l'installation d'alimentation électrique servant de source d'énergie pour les dispositifs de capteur.

6. Système selon la revendication 1, dans lequel le dispositif de capteur a un contact physique avec l'installation d'alimentation électrique qui doit être surveillée.

7. Système selon la revendication 1, dans lequel l'unité de traitement est connectée aux moyens pour communiquer sans fil avec une unité externe de transmission du signal d'indication ou d'autres informations liées au signal d'indication.

8. Système selon la revendication 7, dans lequel l'unité externe est un centre de surveillance, un téléphone mobile, un ordinateur ou similaire.

9. Système selon la revendication 6, dans lequel le dispositif de capteur comprend un transformateur pour transformer une tension d'une haute tension à une tension de distribution.

10. Procédé de surveillance de charges de température, de force du vent, de tension et/ou de hauteur dans des installations d'alimentation électrique, comprenant :
- la mise en place d'au moins deux dispositifs de capteur tels que dans l'une quelconque des revendications 1 à 9 dans l'installation d'alimentation électrique à surveiller, où chaque dispositif de capteur comprend un émetteur de signaux RFID propre à recevoir et à répondre à des signaux radiofréquence,
- la transmission de signaux de capteur depuis l'un des dispositifs de capteur au moyen de son émetteur de signaux RFID ;
- la réception de signaux en provenance de l'émetteur de signaux RFID au moyen des un ou plusieurs récepteurs de signaux et le relais des signaux reçus ; et
- le traitement des signaux et la fourniture d'un signal d'indication qui est communiqué à un centre de surveillance, un téléphone mobile ou un ordinateur.

11. Procédé selon la revendication 10, dans lequel les dispositifs de capteur mesurent une force du vent, une tension et/ou une hauteur au-dessus du sol.

12. Procédé selon la revendication 10, dans lequel les émetteurs de signaux et les récepteurs de signaux sont des émetteurs et des lecteurs de signaux électromagnétiques.

13. Procédé selon la revendication 10, dans lequel le signal reçu en provenance d'un autre dispositif de capteur est relayé au moyen de l'émetteur de signaux.
